# EUROPÄISCHE PATENTANMELDUNG

(11) **EP 2 816 610 A1**
(43) Veröffentlichungstag der Anmeldung: **24.12.2014**
(21) Anmeldenummer: 14171882.5
(22) Anmeldetag: 11.06.2014
(51) Int. Cl.: H01L 31/0224, H01L 31/068, H01L 31/18

(54) **Wafersolarzelle und Solarzellenherstellungsverfahren**

(30) Priorität: 17.06.2013 DE 102013106272
(71) Anmelder: Hanwha Q.CELLS GmbH, 06766 Bitterfeld-Wolfen (DE)
(72) Erfinder: Bordihn, Stefan, 04109 Leipzig (DE); Mertens, Verena, 04109 Leipzig (DE); Stenzel, Florian, 04315 Leipzig (DE); Cieslak, Janko, 06766 Wolfen (DE)
(74) Vertreter: adares Patent- und Rechtsanwälte Reininger & Partner

(57) **Zusammenfassung**

Die Erfindung betrifft eine Wafersolarzelle mit einer Halbleiterschicht (1), einer rückseitigen Emitterschicht (2), einer auf der Emitterschicht (2) angeordneten Passivierschicht (3), in der Öffnungen (31) gebildet sind, und einer auf der Passivierschicht (3) angeordneten Metallisierungsschicht (4), wobei die Emitterschicht (2), die Passivierschicht (3) und/oder die Metallisierungsschicht (4) eine Solarzellenrückseite im Wesentlichen vollständig bedecken und wobei benachbart zu jeder Öffnung (31) ein Dotierbereich (5) gebildet ist, welcher sich in die Emitterschicht (2) und/oder in die Halbleiterschicht (1) erstreckt und mittels eines Metalls aus der Metallisierungsschicht (4) und/oder aus der Passivierungsschicht (3) dotiert ist. Ferner betrifft die Erfindung ein Solarzellenherstellungsverfahren zur Herstellung einer solchen Wafersolarzelle.

## Beschreibung

Die Erfindung betrifft eine Wafersolarzelle und ein Solarzellenherstellungsverfahren.

Waferbasierte Solarzellen mit Rückseitenemittern, also mit einer rückseitig, das heißt auf einer lichtabgewandten Oberfläche der Solarzelle, angeordneten Emitterschicht, stellen eine wichtige alternative Technologie zu üblichen Solarzellenstrukturen dar, bei denen die Emitterschicht auf der Lichteinfallseite angeordnet ist. Mit dieser Technologie lassen sich insbesondere sehr effiziente Solarzellen auf Basis von n-Typ Halbleiterwafern erzeugen. Eine mögliche Realisierung einer rückseitigen Emitterschicht besteht darin, eine geeignete Metallpaste auf die Rückseitenoberfläche des Halbleiterwafers aufzubringen und diese anschließend einem Feuerschritt auszusetzen. Hierdurch dringen Metallelemente aus der Metallpaste in den Halbleiter ein und erzeugen eine dotierte Emitterschicht auf der Halbleiteroberfläche. Gleichzeitig wird eine mit der Emitterschicht kontaktierte Metallisierungsschicht erzeugt.

Um die Effizienz der Solarzelle zu steigern, wäre es von Vorteil, auf der Emitterschicht eine Passivierungsschicht vorzusehen. Das vorangehend beschriebene Verfahren eignet sich jedoch nicht für die Herstellung einer derartigen Struktur. Stattdessen erfolgt herkömmlicherweise die Herstellung einer selektiven Emitterstruktur mittels selektiver Diffusion, wobei anschließend eine Kontaktierung mittels eines Silber-Aluminium-Kontaktgitters durchgeführt wird. Dies hat jedoch den Nachteil, dass die Kontaktierung auf der Emitterstruktur justiert werden muss, was zusätzlichen Aufwand mit sich bringt und eine zusätzliche Fehlerquelle darstellt.

Es ist Aufgabe der Erfindung, eine effiziente und kostengünstige waferbasierte Solarzelle mit rückseitigem Emitter und ein verlässliches Herstellungsverfahren hierfür bereitzustellen.

Die Aufgabe wird gemäß der Erfindung durch eine Wafersolarzelle mit den Merkmalen des Anspruchs 1 und ein Solarzellenherstellungsverfahren mit den Merkmalen des Anspruchs 8 gelöst. Vorteilhafte Weiterbildungen der Erfindung sind in den Unteransprüchen aufgeführt.

Die Erfindung beruht auf der Überlegung, die für die Kontaktierung der Emitterschicht notwendigen Dotierbereiche und die ebenfalls für die Kontaktierung der Emitterschicht notwendigen Öffnungen in der Passivierschicht auf einfache Weise miteinander zu justieren. Hierbei wird eine Art Selbstjustierung eingesetzt, indem die Lage der Öffnungen in der Passivierschicht die Lage der Dotierbereiche vorgibt. Es ergeben sich hierfür zwei unterschiedliche Varianten der Herstellung: In einer ersten Variante werden die Öffnungen in der Passivierschicht derart gebildet, dass gleichzeitig die Dotierbereiche entstehen, beispielsweise mittels Laserdotierung, wenn die Öffnungen mittels Laser erzeugt werden. In einer zweiten Variante werden die Öffnungen vor dem Erzeugen der Dotierung in der Passivierschicht gebildet, und ein nachträglicher Metallisierungsschritt ist so ausgewählt, dass dabei gleichzeitig die Dotierbereiche entstehen, und zwar aufgrund der vorhergehenden Strukturierung der Passivierschicht nur in den Öffnungen. Diese beiden grundlegenden Varianten finden sich in Reinform, mit Abwandlungen oder in Mischformen in den nachfolgend beschriebenen besonderen Ausführungsformen.

Ergebnis dieser Vorgehensweise ist, dass benachbart zu jeder Öffnung ein Dotierbereich gebildet ist, welcher sich in die Emitterschicht und gegebenenfalls auch in die Halbleiterschicht erstreckt und dass die Dotierung mittels eines Metalls aus der Metallisierungsschicht und/oder aus der Passivierungsschicht ausgebildet ist. Das bedeutet insbesondere, dass ein Metall, welches in der Metallisierungsschicht und/oder in der Passivierungsschicht in einer chemischen Verbindung oder einer Legierung vorliegt, als Dotierstoff in dem Dotierbereich vorliegt.

Benachbart zu jeder Öffnung bedeutet hierbei, dass der oder die Dotierbereiche an einer jeweiligen Öffnung angrenzen, also bei Aufsicht auf die Solarzellenrückseite innerhalb der Öffnung oder in unmittelbarer Umgebung um die Öffnung vorliegen.

Ein Vorteil dieses Verfahrens besteht darin, dass die Emitterschicht oder die Metallisierungsschicht oder insbesondere beide Schichten trotz einer dazwischenliegenden Passivierschicht vollflächig erzeugt sein können, ohne eine zusätzliche Justierung zwischen dem Emitter und der Metallisierung notwendig zu machen. Dass die Emitterschicht, die Passivierschicht und/oder die Metallisierungsschicht die Solarzellenrückseite im Wesentlichen vollständig bedecken, bedeutet, dass eine, zwei oder drei dieser Schichten vollflächig auf der Solarzellenrückseite angeordnet sind. Lediglich an den besagten Öffnungen, in Randbereichen und/oder in anderen produktionsbedingten Bereichen können Aussparungen vorgesehen sein.

Die Öffnungen in der Passivierschicht können punktförmig oder linienförmig sein. Punkförmige Öffnungen können Durchmesser in der Größenordnung von einigen 10 Mikrometern (µm) bis zu einigen 100 µm aufweisen. Linienförmige Öffnungen können Liniendicken von etwa 10 µm bis einige 100 µm aufweisen.

Bei einer bevorzugten Ausführungsform ist vorgesehen, dass sich die Öffnungen in oder durch die Emitterschicht und/oder durch die Metallisierungsschicht erstrecken. Das bedeutet, die Öffnungen können als Ausnehmungen teilweise in die Emitterschicht reichen, oder sie können als Löcher die Emitterschicht durchdringen. Wenn die Öffnungen Löcher in der Emitterschicht bilden, dann können sie zudem teilweise in die Halbleiterschicht hineinreichen.

In einer vorteilhaften Weiterbildung ist vorgesehen, dass die Metallisierungsschicht die Öffnungen in der Passivierschicht ausfüllt. Das bedeutet, dass die Metallisierungsschicht in die Öffnungen hineinragt. Dies geschieht insbesondere dann, wenn die Öffnungen vor dem Aufbringen oder Abscheiden der Metallisierungsschicht erzeugt werden, beispielsweise wenn nach dem Herstellen der Öffnungen eine Metallpaste auf die Solarzellenrückseite aufgetragen wird und somit auch in die Öffnungen eindringt.

Gemäß einer zweckmäßigen Ausgestaltung ist vorgesehen, dass die Halbleiterschicht aus einem n-Typ Halbleiter, insbesondere aus einem n-Typ Silizium gebildet ist. In diesem Fall ist die Emitterschicht vorzugsweise als p-Typ Emitter ausgebildet. Dementsprechend sind die Dotierbereiche bevorzugterweise ein stärker dotierter p-Typ Bereich, was üblicherweise als Bereichs des Typs p+ oder p++ bezeichnet wird.

Bei einer zweckmäßigen Ausführungsform ist vorgesehen, dass die Metallisierungsschicht aluminiumhaltig ist. Es kann sich also um eine mittels einer aluminiumhaltigen Paste hergestellte Metallisierungsschicht handeln. Andererseits kann die Metallisierungsschicht auch als Aluminium- oder aluminiumhaltige Schicht abgeschieden sein, insbesondere mittels eines Verdampfungsverfahrens. Bei einer aluminiumhaltigen Metallisierungsschicht kann die Dotierung des Dotierbereichs durch das Aluminium aus der Metallisierungsschicht oder aus der Metallpaste herrühren. Eine aluminiumhaltige Paste hat gegenüber einer silberhaltigen Paste den Vorteil, dass sie bei einem nachfolgend beschrieben Feuerschritt die Passivierschicht nicht oder nur in einem geringen Maße angreift. Zudem kann mit Aluminium eine p-Dotierung erzielt werden, was bei n-Typ Halbleiterschichten von besonderem Nutzen ist.

Die hier beschriebene Wafersolarzelle weist auf seiner Halbleiterschicht eine rückseitige Emitterschicht auf. Das bedeutet, die Emitterschicht ist auf der beim Einsatz der Solarzelle lichtabgewandten Seite der Halbleiterschicht, also auf der Solarzellenrückseite gebildet. Die Emitterschicht kann hierbei als eine zusätzliche Schicht auf der Halbleiterschicht-Rückseite aufgebracht sein. Eher bevorzugt ist es jedoch, wenn die Emitterschicht als eine Dotierschicht in der Halbleiterschicht gebildet ist. Vorliegend werden hauptsächlich diese Solarzellenrückseite und die darauf angeordneten Schichten und Strukturen beschrieben. Auf der Solarzellenvorderseite kann die Solarzelle auf jede geeignete Art vorbereitet sein, beispielsweise mit einem Front-Surface-Field (FSF), mit einer Antireflexionsschicht, vorderseitig aufgebrachten Kontaktfingern oder Kontaktgitter und/oder einer vorderseitigen Passivierschicht.

Bevorzugterweise ist vorgesehen, dass der Dotierbereich eine höhere Dotierung ausweist, als die Emitterschicht. Das bedeutet, dass die Dichte der Majoritätsladungsträger bei einer bestimmten Temperatur in den Dotierbereichen größer ist, als in der Emitterschicht.

Um die hier beschriebene Wafersolarzelle herzustellen, wird zunächst ein Halbleiterwafer mit einer Halbleiterschicht bereitgestellt. Auf oder in dieser Halbleiterschicht wird eine Emitterschicht erzeugt, und zwar auf der Solarzellenrückseite des Halbleiterwafers, welche bei der fertigen Solarzelle von der Lichteinfallseite abgewandt ist. Auf die Emitterschicht wird dann eine Passivierschicht abgeschieden, welche für eine Oberflächenpassivierung sorgt. Die Passivierschicht ist hierfür aus einem geeigneten dielektrischen Material gebildet, beispielsweise aus Siliziumoxid, Siliziumnitrid, Siliziumoxinitrid, Aluminiumoxid, Aluminiuoxinitrid oder dergleichen.

Im Laufe des Verfahrens wird außerdem eine Metallisierungsschicht auf der Passivierschicht erzeugt. Die Metallisierungsschicht kann hierbei mittels eines Abscheideverfahrens, beispielswiese mittels Verdampfung (PVD, physical vapour deposition, also Abscheidung aus der Gasphase) hergestellt werden. Vorteilhafterweise kann aber vorgesehen sein, dass das Erzeugen der Metallisierungsschicht auf der Passivierschicht ein Aufbringen einer Metallpaste auf die Passivierschicht und ein Erwärmen des Halbleiterwafers und der aufgebrachten Metallpaste zur Erzeugung einer Metallisierungsschicht umfasst. Bei diesem, als Pastenmetallisierung bekanntem Verfahren, kann die Metallpaste beispielsweise mittels eines Siebdruckverfahrens auf die Passivierschicht aufgetragen werden.

Zudem werden in der in der Passivierungsschicht Öffnungen erzeugt. Zeitgleich mit der Herstellung der Öffnungen oder in einem späteren Verfahrensschritt wird ein Dotierbereich benachbart zu jeder Öffnung derart erzeugt, dass sich der Dotierbereich in die Emitterschicht und/oder in die Halbleiterschicht erstreckt und mittels eines Metalls aus der Metallisierungsschicht und/oder aus der Passivierungsschicht dotiert ist.

In einer vorteilhaften Ausgestaltung ist vorgesehen, dass das Erzeugen der Öffnungen in der Passivierungsschicht vor dem Erzeugen der Metallisierungsschicht erfolgt. Die Öffnungen werden hierbei in der Passivierungsschicht gebildet, ohne dass eine Metallisierungsschicht die Passivierschicht bedeckt. Wenn die Öffnungen mittels Einbringung von Energie, beispielsweise mittels eines Lasers, erzeugt werden, dann kann diese Energie gleichzeitig Material aus der Passivierschicht, insbesondere das Metall aus der Passivierschicht, in die Emitterschicht und/oder die Halbleiterschicht treiben und so die Dotierbereiche erzeugen. In einem nachfolgenden Schritt kann dann die Metallisierungsschicht erzeugt werden, die zwangsläufig auch in die Öffnungen dringt und diese vorzugsweise ausfüllt. Wenn die Metallisierungsschicht mittels einer Temperaturbehandlung erzeugt wird, beispielsweise indem eine Metallpaste aufgetragen und anschließend ein Feuerschritt durchgeführt wird, dann können die Dotierbereiche aufgrund der Temperaturbehandlung erzeugt werden, indem nämlich Dotierstoffe aus der Metallpaste in die Emitterschicht und/oder in die Halbleiterschicht gelangen.

Gemäß einer bevorzugten Weiterbildung ist vorgesehen, dass das Erzeugen der Öffnungen in der Passivierungsschicht nach dem Erzeugen der Metallisierungsschicht und gleichzeitig mit dem Erzeugen des Dotierbereiches erfolgt. Wenn die Öffnungen mittels Einbringung von Energie, beispielsweise mittels eines Lasers, erzeugt werden, dann kann diese Energie gleichzeitig Material aus der Passivierschicht und/oder aus der Metallisierungsschicht, insbesondere das Metall aus der Metallisierungsschicht, in die Emitterschicht und/oder die Halbleiterschicht treiben und so die Dotierbereiche erzeugen.

Gemäß einer bevorzugten Ausgestaltung des Herstellungsverfahrens für den Fall, dass die Metallisierungsschicht mittels Pastenmetallisierung erfolgt, ist vorgesehen, dass das Erzeugen der Öffnungen in der Passivierungsschicht nach dem Aufbringen der Metallpaste auf die Passivierschicht erfolgt. Die Öffnungen können hierbei noch vor dem nachfolgend beschriebenen Feuerschritt erfolgen, also noch während das Metall in Form der Metallpaste auf der Solarzellenrückseite vorliegt.

Bevorzugterweise ist bei der Durchführung einer Pastenmetallisierung vorgesehen, dass das Erwärmen des Halbleiterwafers und der aufgebrachten Metallpaste zur Erzeugung der Metallisierungsschicht in einem Zweischrittverfahren erfolgt, wobei während eines ersten Erwärmungsschrittes eine Trocknung der aufgebrachten Metallpaste bei einer Temperatur von zwischen 150°C und 500 °C erfolgt und während eines nachfolgenden zweiten Erwärmungsschrittes ein Einbrennen der eingetrockneten Metallpaste bei einer Temperatur von zwischen 700°C und 1000 °C erfolgt. Wenn in der Passivierschicht noch keine Öffnungen gebildet sind, dann führt der Feuerschritt zwar dazu, dass die so erzeugte Metallschicht an der Passivierschicht gut haftet, allerdings wird noch kein elektrischer Kontakt zwischen der Metallschicht und der Emitterschicht erzeugt. Dies muss dann in einem nachfolgenden Schritt nachgeholt werden, bei dem gleichzeitig die Öffnungen erzeugt werden.

Die Öffnungen in der Passivierschicht können mit jedem hierzu geeigneten Verfahren hergestellt werden, insbesondere mit einem Verfahren, bei der Energie in die Passivierschicht und in die umliegenden Strukturen und Schichten eingebracht wird. In einer zweckmäßigen Weiterbildung ist vorgesehen, dass die Öffnungen in der Passivierungsschicht mittels Laserbestrahlung erzeugt werden. In diesem Fall kann die Laserbestrahlung gleichzeitig dazu führen, dass das Metall aus der Passivierschicht und/oder aus der Metallisierungsschicht in die Emitterschicht und/oder die Halbleiterschicht dringt, um die Dotierbereiche zu bilden. Es handelt sich dann also um eine Laserdotierung.

Die Erfindung wird im Folgenden anhand von Ausführungsbeispielen unter Bezugnahme auf die Figuren erläutert. Hierbei zeigen:
- Fig. 1a bis 1e: die schrittweise Herstellung einer Wafersolarzelle gemäß einer Ausführungsform; und
- Fig. 2a bis 2e: die schrittweise Herstellung einer Wafersolarzelle gemäß einer weiteren Ausführungsform.

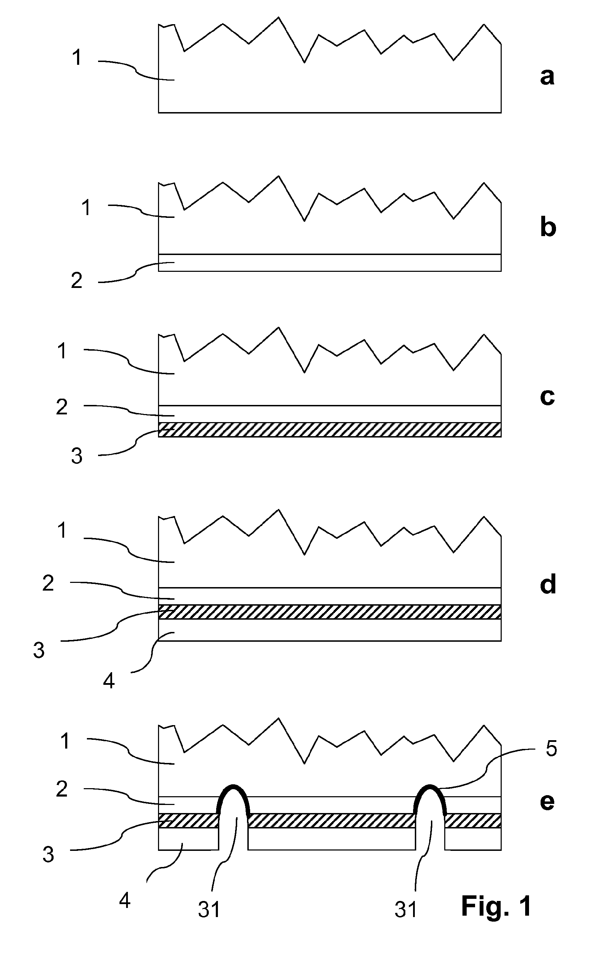

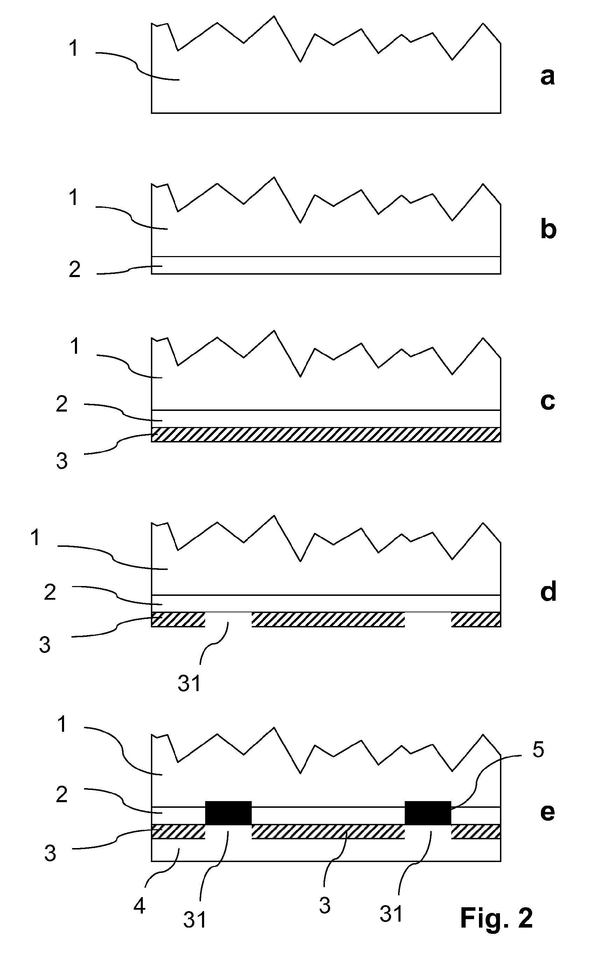

Die Fig. 1 zeigt eine Abfolge von Zwischenprodukten bei der Herstellung einer Wafersolarzelle gemäß einer besonderen Ausführungsform, bei der die Öffnungen in der Passivierschicht nach dem Herstellen der Metallisierungsschicht erzeugt werden. Wie in der Fig. 2, wird hier lediglich die Solarzellenrückseite, das heißt, die bei der fertigen Solarzelle als lichtabgewandte Seite fungierende Solarzellenseite, betrachtet. Die gezackte Linie in den Darstellungen stellt also nicht die Solarzellenvorderseite oder Solarzellenlichteinfallseite dar, sondern soll gerade veranschaulichen, dass die Solarzellenvorderseite hier nicht betrachtet wird und jede geeignete Form beziehungsweise jede geeignete Schichtenfolge aufweisen kann.

Wie in der Fig. 1a dargestellt, wird zunächst eine Halbleiterschicht 1 in Form eines Halbleiterwafers bereitgestellt. Auf dieser Halbleiterschicht 2 wird, wie in Fig. 1b gezeigt, rückseitig eine Emitterschicht 2 erzeugt, entweder mittels Abscheidung eines geeigneten Halbleitermaterials oder mittels Dotierung der Halbleiterschicht 2 auf seiner Rückseite. Wie in Fig. 1c dargestellt, wird auf die Emitterschicht 2 eine Passivierschicht 3 abgeschieden, die für eine Oberflächenpassivierung sorgt. Schließlich wird eine Metallisierungsschicht 4, wie in Fig. 1d dargestellt, auf der Passivierungsschicht erzeugt.

Um anschließend eine elektrische Verbindung zwischen der Metallisierungsschicht 4 und der Emitterschicht 2 herzustellen, werden mittels Laserablation Öffnungen 31 in der Passivierungsschicht 3 erzeugt, die sich im vorliegenden Fall auch durch die Emitterschicht 2 und sogar teilweise als Ausnehmungen in die Halbleiterschicht 1 erstrecken. Aufgrund der durch den Laser eingebrachten Energie werden zudem Elemente aus der Metallisierungsschicht 4 und/oder aus der Passivierungsschicht 3, insbesondere ein in diesen Schichten enthaltenes Metall in die Emitterschicht 2 und in die Halbleiterschicht 1 eingetrieben und erzeugen dort Dotierbereiche 5 in der unmittelbaren Umgebung der Öffnungen 3. Der Laser dient somit nicht nur der Öffnung der Passivierungsschicht 3, sondern auch dazu, mittels Laserdotierung die Dotierbereiche 5 zu erzeugen.

Anhand der in den Fig. 2a bis 2e dargestellten Bildfolge wird ein abgewandeltes Verfahren zur Erzeugung einer elektrischen Verbindung zwischen einer rückseitigen Emitterschicht 2 und einer Metallisierungsschicht 4 veranschaulicht. Hierbei entsprechen die Verfahrensschritte gemäß Fig. 2a, 2b und 2c bis zur Abscheidung der Passivierungsschicht 3 den in Fig. 1a, 1b und 1c dargestellten Verfahrensschritten. Gemäß der Fig. 2d werden nun aber vor dem erzeugen einer Metallisierungsschicht 4 die Öffnungen 31 in der Passivierschicht 3 erzeugt, vorzugsweise mittels Laserbestrahlung.

Erst in einem anschließenden Schritt wird die Metallisierungsschicht 4 auf der Passivierungsschicht 3 gebildet, so dass sich die Metallisierungsschicht 4 auf in die Öffnungen 31 erstreckt. Entweder während der Erzeugung der Metallisierungsschicht 4, insbesondere während des Feuerschrittes bei Einsatz einer Pastenmetallisierung, oder nach dem Erzeugung der Metallisierungsschicht 4, zum Beispiel ebenfalls mittels Laserdotierung, werden die Dotierbereiche 5 unterhalb der Öffnungen 31 in der Emitterschicht 2 erzeugt. Wie in der Fig. 2e dargestellt, erstrecken sich die Dotierbereiche 5 auch hier teilweise in die Halbleiterschicht 1. Anders als in dem in Fig. 1e dargestellten Fall erstrecken sich die Öffnungen 31 jedoch nicht in die Emitterschicht 2, was jedoch von den einzelnen Prozessparametern wie Laserleistung, Bestrahlungsdauer und dergleichen abhängt.

### Bezugszeichenliste:

- 1: Halbleiterschicht
- 2: Emitterschicht
- 3: Passivierschicht
- 31: Öffnung in der Passivierschicht
- 4: Metallisierungsschicht
- 5: Dotierbereich

## Patentansprüche

1. Wafersolarzelle mit einer Halbleiterschicht (1), einer rückseitigen Emitterschicht (2), einer auf der Emitterschicht (2) angeordneten Passivierschicht (3), in der Öffnungen (31) gebildet sind, und einer auf der Passivierschicht (3) angeordneten Metallisierungsschicht (4), wobei die Emitterschicht (2), die Passivierschicht (3) und/oder die Metallisierungsschicht (4) eine Solarzellenrückseite im Wesentlichen vollständig bedecken und wobei benachbart zu jeder Öffnung (31) ein Dotierbereich (5) gebildet ist, welcher sich in die Emitterschicht (2) und/oder in die Halbleiterschicht (1) erstreckt und mittels eines Metalls aus der Metallisierungsschicht (4) und/oder aus der Passivierungsschicht (3) dotiert ist.

2. Wafersolarzelle nach Anspruch 1, **dadurch gekennzeichnet, dass** sich die Öffnungen (31) in oder durch die Emitterschicht (2) und/oder durch die Metallisierungsschicht (4) erstrecken.

3. Wafersolarzelle nach Anspruch 1, **dadurch gekennzeichnet, dass** die Metallisierungsschicht (4) die Öffnungen (31) in der Passivierschicht (3) ausfüllt.

4. Wafersolarzelle nach einem der vorangehenden Ansprüche, **dadurch gekennzeichnet, dass** die Halbleiterschicht (1) aus einem n-Typ Halbleiter gebildet ist.

5. Wafersolarzelle nach einem der vorangehenden Ansprüche, **dadurch gekennzeichnet, dass** die Metallisierungsschicht (4) aluminiumhaltig ist.

6. Wafersolarzelle nach einem der vorangehenden Ansprüche, **dadurch gekennzeichnet, dass** die Emitterschicht (2) als eine Dotierschicht in der Halbleiterschicht (1) gebildet ist.

7. Wafersolarzelle nach Anspruch 6, **dadurch gekennzeichnet, dass** der Dotierbereich (5) eine höhere Dotierung ausweist, als die Emitterschicht (2).

8. Solarzellenherstellungsverfahren mit folgenden Verfahrensschritten:
- Bereitstellen eines Halbleiterwafers mit einer Halbleiterschicht (1);
- Erzeugen einer Emitterschicht (2) auf einer bei der fertigen Solarzelle von der Lichteinfallseite abgewandten Solarzellenrückseite des Halbleiterwafers;
- Abscheiden einer Passivierschicht (3) auf der Emitterschicht (2);
- Erzeugen einer Metallisierungsschicht (4) auf der Passivierschicht (3);
- Erzeugen von Öffnungen (31) in der Passivierungsschicht (3); und
- Erzeugen eines Dotierbereiches (5) benachbart zu jeder Öffnung (31) derart, dass sich der Dotierbereich (5) in die Emitterschicht (2) und/oder in die Halbleiterschicht (1) erstreckt und mittels eines Metalls aus der Metallisierungsschicht (4) und/oder aus der Passivierungsschicht (3) dotiert ist.

9. Solarzellenherstellungsverfahren nach Anspruch 8, **dadurch gekennzeichnet, dass** das Erzeugen der Öffnungen (31) in der Passivierungsschicht (3) vor dem Erzeugen der Metallisierungsschicht (4) erfolgt.

10. Solarzellenherstellungsverfahren nach Anspruch 8, **dadurch gekennzeichnet, dass** das Erzeugen der Öffnungen (31) in der Passivierungsschicht (3) nach dem Erzeugen der Metallisierungsschicht (4) und gleichzeitig mit dem Erzeugen des Dotierbereiches (5) erfolgt.

11. Solarzellenherstellungsverfahren nach einem der Ansprüche 8 bis 10, **dadurch gekennzeichnet, dass** das Erzeugen der Metallisierungsschicht (4) auf der Passivierschicht (3) ein Aufbringen einer Metallpaste auf die Passivierschicht (3) und ein Erwärmen des Halbleiterwafers und der aufgebrachten Metallpaste zur Erzeugung einer Metallisierungsschicht (4) umfasst.

12. Solarzellenherstellungsverfahren nach Anspruch 11, **dadurch gekennzeichnet, dass** das Erzeugen der Öffnungen (31) in der Passivierungsschicht (3) nach dem Aufbringen der Metallpaste auf die Passivierschicht (3) erfolgt.

13. Solarzellenherstellungsverfahren nach Anspruch 11 oder 12, **dadurch gekennzeichnet, dass** das Erwärmen des Halbleiterwafers und der aufgebrachten Metallpaste zur Erzeugung der Metallisierungsschicht (4) in einem Zweischrittverfahren erfolgt, wobei während eines ersten Erwärmungsschrittes eine Trocknung der aufgebrachten Metallpaste bei einer Temperatur von zwischen 150°C und 500 °C erfolgt und während eines nachfolgenden zweiten Erwärmungsschrittes ein Einbrennen der Eingetrockneten Metallpaste bei einer Temperatur von zwischen 700°C und 1000 °C erfolgt.

14. Solarzellenherstellungsverfahren nach einem der Ansprüche 8 bis 13, **dadurch gekennzeichnet, dass** die Öffnungen (31) in der Passivierungsschicht (3) mittels Laserbestrahlung erzeugt werden.
